# EUROPEAN PATENT APPLICATION

(11) **EP 4 654 481 A1**
(43) Date of publication of application: **26.11.2025**
(21) Application number: 25164884.6
(22) Date of filing: 19.03.2025
(51) Int. Cl.: H03K 19/00, H03K 19/0175

(54) **DEVICE INCLUDING BIDIRECTIONAL DATA TRANSCEIVER AND METHOD OF OPERATING THE SAME**

(30) Priority: 24.05.2024 KR 20240068022; 26.07.2024 KR 20240099707
(71) Applicant: Samsung Electronics Co., Ltd., Suwon-si, Gyeonggi-do 16677 (KR); Seoul National University R&DB Foundation, Seoul 08826 (KR)
(72) Inventor: LEE, Jusung, 16677 Suwon-si (KR); KIM, Suhwan, 16677 Suwon-si (KR)
(74) Representative: Marks & Clerk LLP

(57) **Abstract**

A device for transmitting first data to an external device and receiving second data from the external device is provided. The device includes: a voltage mode driver connected to a first node, the voltage mode driver including a pull-up resistor circuit and a pull-down resistor circuit, the pull-up resistor circuit including a plurality of pull-up resistors, and the pull-down resistor circuit including a plurality of pull-down resistors; a current source circuit connected to a second node and including a first current source and a second current source; a pre-driver configured to control the voltage mode driver and the current source circuit, based on the first data; a receiver connected to the second node and configured to obtain the second data based on a voltage level of the second node; and a hybrid resistor connected between the first node and the second node.

## Description

### BACKGROUND

The present disclosure relates to a device including a bidirectional data transceiver and a method of operating the same.

When a device is configured to send and receive signals in both directions with another device using simultaneous bidirectional signaling (SBD), the outbound signal, which is the signal being transmitted, is superimposed on the inbound signal, which is the signal being received, on the transmission line connecting the two devices. In this case, at the receiving end, it is necessary to remove an outbound signal from the superimposed signal in order to correctly receive the signal provided by the other party.

There is a need to design a chip that may remove the outbound signal from the superimposed signal, while improving pin efficiency and data rate of the semiconductor chip and reducing the power consumption of the chip.

### SUMMARY

One or more embodiments provide a method capable of removing an outbound signal from a superimposed signal, improving pin efficiency and data rate of a semiconductor chip, and reducing power consumption of the semiconductor chip.

The present invention is not limited to solving the technical problems mentioned above, and other technical problems not mentioned are clearly understood by those skilled in the art from the description below.

According to an aspect of an embodiment, a device configured to transmit first data to an external device and receive second data from the external device, includes: a voltage mode driver electrically connected to a first node, the voltage mode driver including a pull-up resistor circuit and a pull-down resistor circuit, the pull-up resistor circuit including a plurality of pull-up resistors, and the pull-down resistor circuit including a plurality of pull-down resistors; a current source circuit electrically connected to a second node and including a first current source and a second current source; a pre-driver configured to control the voltage mode driver and the current source circuit, based on the first data; a receiver electrically connected to the second node and configured to obtain the second data based on a voltage level of the second node; and a hybrid resistor electrically connected between the first node and the second node.

According to another aspect of an embodiment, a method of controlling a device for transmitting first data to an external device and receiving second data from the external device, includes: calibrating a voltage mode driver using a calibration circuit; calibrating a current source circuit using the calibration circuit; adjusting a resistance value of a pull-up resistor circuit of the voltage mode driver, based on the first data; adjusting a resistance value of a pull-down resistor circuit of the voltage mode driver, based on the first data; adjusting a calibration current of the current source circuit, based on the first data; and obtaining the second data, based on a voltage level applied to a receiver.

According to another aspect of an embodiment, a device configured to transmit first data to an external device and receive second data from the external device, includes: a voltage mode driver electrically connected to a first node, the voltage mode driver including a pull-up resistor circuit including plurality of pull-up resistors and a pull-down resistor circuit including a plurality of pull-down resistors; a current source electrically connected between a power voltage and a second node; a pre-driver configured to control the voltage mode driver and the current source, based on the first data; a receiver electrically connected to the second node, and configured to obtain the second data based on a voltage level of the second node; and a hybrid resistor electrically connected between the first node and the second node.

At least some of the above and other features are set out in the claims.

### BRIEF DESCRIPTION OF DRAWINGS

The above and other aspects and features will be more apparent from the following description of embodiments, taken in conjunction with the accompanying drawings, in which:
FIG. 1 is a block diagram showing an integrated circuit according to an embodiment;
FIG. 2 is a block diagram showing an integrated circuit according to an embodiment;
FIG. 3 is a circuit diagram showing a transceiver according to an embodiment;
FIGS. 4A, 4B, 4C and 4D are circuit diagrams showing a transceiver according to an embodiment;
FIG. 5 is a circuit diagram showing a calibration circuit according to an embodiment;
FIG. 6 is a circuit diagram showing a calibration circuit according to an embodiment;
FIG. 7 is a circuit diagram showing a calibration circuit according to an embodiment;
FIGS. 8A, 8B, 8C and 8D are circuit diagrams showing a transceiver according to an embodiment;
FIG. 9 is a flowchart for explaining an operation method of a device, according to an embodiment;
FIG. 10 is a flowchart for explaining an operation method of a device, according to an embodiment;
FIG. 11 is a flowchart for explaining an operation method of a device, according to an embodiment; and
FIG. 12 is a block diagram illustrating a system including a memory device including a device according to embodiments.

### DETAILED DESCRIPTION

Hereinafter, embodiments are described in detail with reference to the attached drawings. When explaining with reference to drawings, identical or corresponding components are given the same drawing reference numerals and descriptions already given therefor are omitted. It will be understood that when an element or layer is referred to as being "on," "connected to" or "coupled to" another element or layer, it can be directly on, connected or coupled to the other element or layer, or intervening elements or layers may be present. By contrast, when an element is referred to as being "directly on," "directly connected to" or "directly coupled to" another element or layer, there are no intervening elements or layers present. Embodiments described herein are example embodiments, and thus, the present disclosure is not limited thereto, and may be realized in various other forms. Each embodiment provided in the following description is not excluded from being associated with one or more features of another example or another embodiment also provided herein or not provided herein but consistent with the present disclosure.

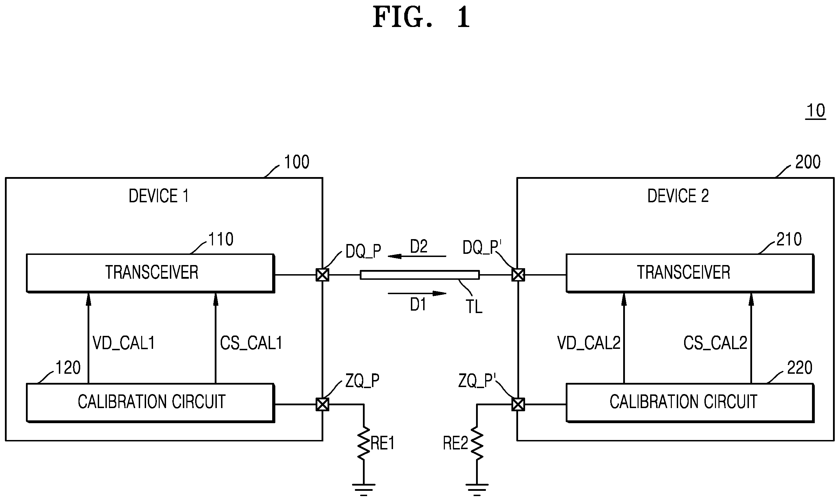

FIG. 1 is a block diagram showing an integrated circuit according to an embodiment.

Referring to FIG. 1, the integrated circuit 10 may include a first device 100, a second device 200, a first external resistor RE1, and a second external resistor RE2.

The first device 100 and the second device 200 may transmit signals through a transmission line TL. The first device 100 may transmit first data D1 to a second device 200 via the transmission line TL. The second device 200 may transmit second data D2 to the first device 100 through the transmission line TL. The transmission line TL may be referred to as a channel. The first device 100 and the second device 200 may simultaneously transmit data (i.e., data may be simultaneously transmitted in different directions), and in this case, a signal corresponding to the first data D1 may be superimposed on a signal corresponding to the second data D2 on the transmission line TL.

In an embodiment, the first device 100 and the second device 200 may be various types of memory devices such as dynamic random access memory (DRAM) or flash memory, or may be controllers that control the various types of memory devices.

The first device 100 may include a transceiver 110 and a calibration circuit 120. The transceiver 110 may be connected to the transmission line TL via a first DQ pin DQ_P. A DQ pin may be otherwise referred to as a data pin. The calibration circuit 220 may be connected to a first external resistor RE1 via a first ZQ pin ZQ_P. A ZQ pin may be otherwise referred to as an impedance calibration pin.

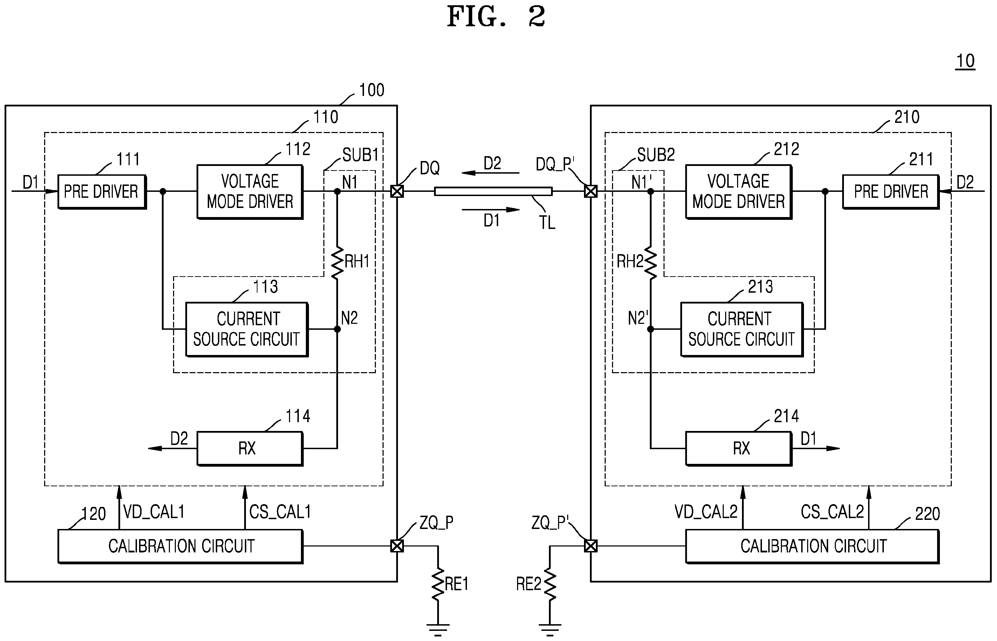

The transceiver 110 may send first data D1 from the first device 100 to the second device 200 while also receiving second data D2 from the second device 200. A detailed description of the configuration of the transceiver 110 is described below with reference to FIG. 2.

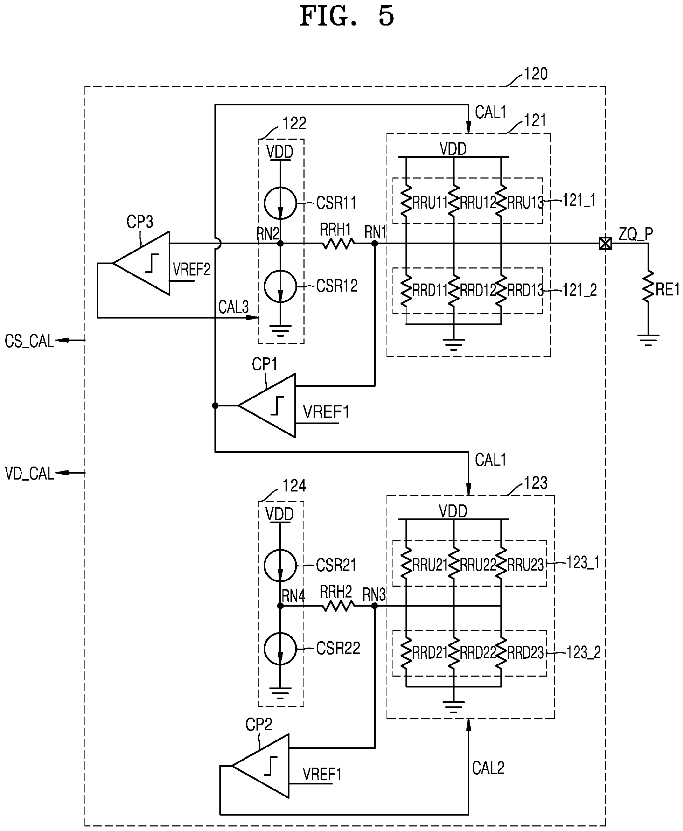

The calibration circuit 120 may be a circuit that calibrates errors in the configuration of the transceiver 110 (e.g., resistance value errors of resistors caused by process, voltage, and temperature (PVT) variation, etc.). The calibration circuit 120 may perform a calibration operation for the transceiver 110 through a first driver calibration signal VD_CAL1 and a first current source circuit calibration signal CS_CAL1. The calibration circuit 120 may be referred to as a ZQ calibration circuit (e.g. an impedance calibration circuit). A detailed description of the configuration of the calibration circuit 120 is described below with reference to FIG. 5.

The second device 200 may have a configuration similar to that of the first device 100. The second device 200 may include a transceiver 210 and a calibration circuit 220. The transceiver 210 may be connected to the transmission line TL via a second DQ pin DQ_P'. The calibration circuit 220 may be connected to a second external resistor RE2 via a second ZQ pin ZQ_P'.

In order to distinguish between the calibration signals of the first calibration circuit 120 and the calibration signals of the second calibration circuit 220, the calibration signals of the first calibration circuit 120 may be referred to as the first driver calibration signal VD_CAL1 and the first current source calibration signal CS_CAL1, respectively. The calibration signals of the second calibration circuit 220 may be referred to as a second driver calibration signal VD_CAL2 and a second current source calibration signal CS_CAL2, respectively. As used herein, such numerical labels such as "first" and "second" may be used to simply distinguish a corresponding feature (e.g. component, signal or value) from another, and does not limit the features in any other aspects (e.g., importance, magnitude or order).

The calibration circuit 220 may perform a calibration operation for the transceiver 210 through a second driver calibration signal VD_CAL2 and a second current source calibration signal CS_CAL2. In addition, in the description of the configuration of the remaining second device, the description already given in the configuration of the first device 100 is omitted.

The first external resistor RE1 and the second external resistor RE2 may be resistors that serve as references, and the calibration circuits 120 and 220 may perform calibration operations using the first external resistor RE1 and the second external resistor RE2 as references. The first external resistor RE1 may serve as a reference for the first calibration circuit 120. The second external resistor RE2 may serve as a reference for the second calibration circuit 220.

FIG. 2 is a block diagram showing an integrated circuit 10 according to an embodiment. FIG. 2 may be a block diagram showing the integrated circuit 10 of FIG. 1 in more detail. FIG. 2 will be described with reference to FIG. 1, and descriptions already given may be omitted.

Referring to FIG. 2, the integrated circuit 10 may include a first device 100, a second device 200, a first external resistor RE1, and a second external resistor RE2. The first device 100 of FIG. 2 may have a similar configuration to the second device 200. The following description focuses on the first device 100, and the description already given may be omitted.

The first device 100 may include a transceiver 110 and a calibration circuit 120. The transceiver 110 may include a pre-driver (i.e., a pre-driver circuit) 111, a voltage mode driver (i.e., a voltage mode driver circuit) 112, a current source circuit 113, a receiver (i.e., a receiver circuit) 114, and a first hybrid resistor RH1. A configuration including the first hybrid resistor RH1 and the current source circuit 113 may be referred to as a subtractor SUB1. Also, in some embodiments, the subtractor may also be referred to as a hybrid circuit. The first hybrid resistor RH1 may be otherwise known as a first subtractor resistor RH1. More generally, the first hybrid resistor RH1 may be known as a first resistor RH1.

The pre-driver 111 may control the voltage mode driver 112 and the current source circuit 113 based on the value corresponding to the first data D1. In the context of the first device 100, the first data D1 may correspond to an outbound signal, which is a signal that the first device 100 intends to transmit to the second device 200. Similarly, in the context of the first device 100, the second data D2 may correspond to an inbound signal.

The voltage mode driver 112 may be electrically connected to a first node N1. The voltage mode driver 112 may include a plurality of resistors and a plurality of switches.

In an embodiment, the pre-driver 111 may control the voltage mode driver 112 by controlling each switch included in the voltage mode driver 112 to a closed state or an open state, based on the first data D1.

The current source circuit 113 may be electrically connected to a second node N2. The current source circuit 113 may include at least one current source.

In an embodiment, the pre-driver 111 may adjust the value of the current output by each current source included in the current source circuit 113, based on the first data D1, or disconnect the electrical connection with the second node N2 by opening (i.e., disconnecting) each current source.

One end of the first hybrid resistor RH1 may be electrically connected to the first node N1, and the other end the first hybrid resistor RH1 may be electrically connected to the second node N2.

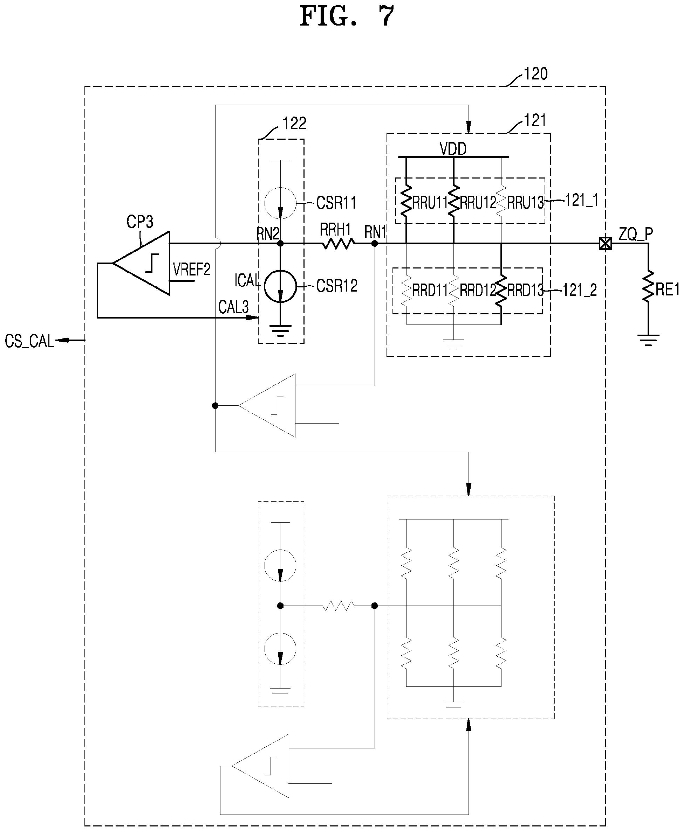

In an embodiment, during the production process of the first device 100, an error may occur in the resistance value indicated by the first hybrid resistor RH1 due to the PVT variation. For example, the resistance value of the first hybrid resistor RH1 intended during design may be 75Ω, but due to the PVT variation, the resistance value of the first hybrid resistor RH1 may be 60Ω. In this case, the first device 100 may offset the effect caused by the error in the resistance value of the first hybrid resistor RH1 (a phenomenon in which the voltage level of the second node N2 does not appear as intended during the design and an error occurs) by performing a current calibration operation that calibrates for the magnitude of the current output by the current source circuit 113 through the calibration circuit 120. In this regard, the difference in voltage level of the second node N2 caused by an error in the resistance value of the first hybrid resistor RH1 may be calibrated. A detailed description of the current calibration operation is provided below with reference to FIG. 7.

The receiver 114 may be electrically connected to the second node N2. The receiver 114 may obtain the second data D2 by decoding the voltage level of the second node N2 into the second data D2. In an embodiment, the first device 100 and the second device 200 may transmit and receive signals, based on the pulse amplitude modulation 4-level (PAM-4) method. In this case, the receiver 114 may decode the received input voltage level (i.e., the voltage level of the second node N2) into one of a first value 2'b00, a second value 2'b01, a third value 2'b10, a the fourth value 2'b11.

In an embodiment, the first device 100 and the second device 200 may transmit data, based on a multi-level signal modulation technique. For example, data transmission between the first device 100 and the second device 200 may be accomplished by modulating a signal using the PAM-4 method. However, this is an example and is not intended to limit the inventive concept. For example, data transmission between the first device 100 and the second device 200 may be implemented using non-return-to-zero (NRZ), PAM-2, or PAM-8.

The calibration circuit 120 may generate a driver calibration signal VD_CAL and a current source circuit calibration signal CS_CAL. The calibration circuit 120 may calibrate the resistance values of the resistors included in the voltage mode driver 112 through the driver calibration signal VD_CAL. The calibration circuit 120 may calibrate the difference in voltage level of the second node N2 caused by an error in the resistance value of the first hybrid resistor RH1 by adjusting a reference current value of the current source circuit 113 through the current source circuit calibration signal CS_CAL.

The second device 200 may include a transceiver 210 and a calibration circuit 220. The transceiver 210 may include a pre-driver 211, a voltage mode driver 212, a current source circuit 213, a receiver 214, and a second hybrid resistor RH2. A configuration including the second hybrid resistor RH2 and the current source circuit 213 may be referred to as a subtractor SUB2. The second hybrid resistor RH2 may be otherwise known as a second subtractor resistor RH2. More generally, the second hybrid resistor RH2 may be known as a second resistor RH2.

In the context of the second device 200, the second data D2 may correspond to an outbound signal, which is a signal that the second device 200 intends to transmit to the first device 100. Similarly, in the context of the second device 200, the first data D1 may correspond to the inbound signal.

One end of the second hybrid resistor RH2 may be electrically connected to the first node N1', and the other end of the second hybrid resistor RH2 may be electrically connected to the second node N2'.

Because the description of the corresponding configurations of the first device 100 may be applied equally to the remaining configurations of the second device 200, the description already given is omitted.

According to an embodiment, signal transmission between the first device 100 and the second device 200 may be implemented in a single ended manner rather than a differential manner. In addition, because the voltage mode driver 112 operates in voltage mode (i.e., the voltage mode driver 112 does not include a current source), power consumption may be reduced compared to a driver that operates in current mode. In addition, because the first device 100 transmits and receives signals with the second device 200 in a simultaneous bidirectional (SBD) manner, the data rate may be improved.

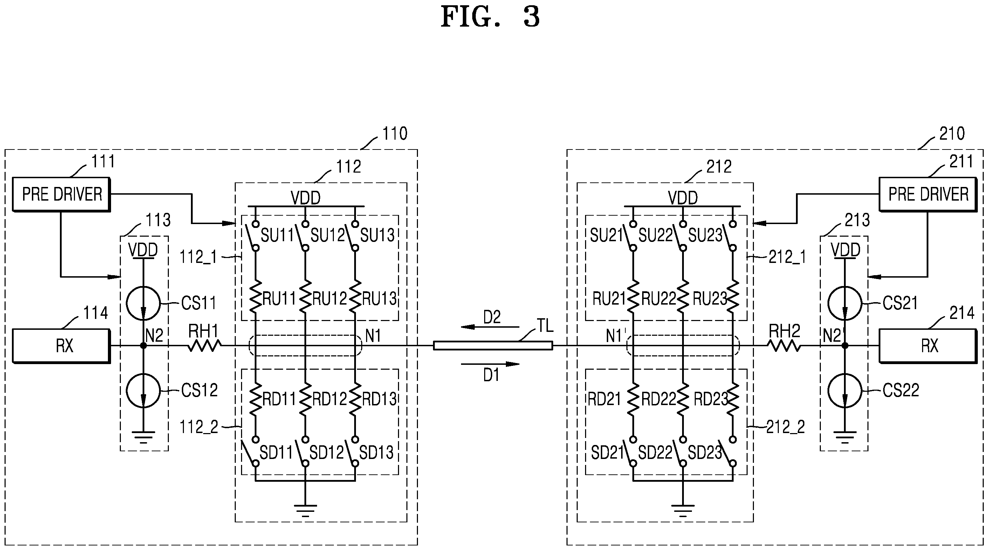

FIG. 3 is a circuit diagram showing a transceiver according to an embodiment. FIG. 3 will be described with reference to FIGS. 1 and 2, and descriptions already given may be omitted.

Referring to FIG. 3, a transceiver 110 and a transceiver 210 may transmit data through a transmission line TL. The transceiver 110 may transmit first data D1 to the transceiver 210. The transceiver 210 may transmit second data D2 to the transceiver 110.

The transceiver 110 may include a pre-driver 111, a voltage mode driver 112, a current source circuit 113, a receiver 114, and a first hybrid resistor RH1.

The voltage mode driver 112 may include a pull-up resistor circuit 112_1 and a pull-down resistor circuit 112_2. The pull-up resistor circuit 112_1 may include a plurality of pull-up resistors RU11, RU12, and RU13 and a plurality of pull-up switches SU11, SU12, and SU13. The pull-down resistor circuit 112_2 may include a plurality of pull-down resistors RD11, RD12, and RD13 and a plurality of pull-down switches SD11, SD12, and SD13. A power supply voltage VDD may be applied to one end of the pull-up resistor circuit 112_1. That is, the one end of the pull-up resistor circuit 112_1 may be connected to a power supply line (e.g. a line configured to provide a power supply voltage VDD). The other end of the pull-up resistor circuit 112_1 may be electrically connected to a first node N1. One end of the pull-down resistor circuit 112_2 may be electrically connected to the first node N1. The other end of the pull-down resistor circuit 112_2 may be electrically connected to ground.

A resistor included in a pull-up resistor circuit 112_1 may be referred to as a pull-up resistor, and a resistor included in a pull-down resistor circuit 112_2 may be referred to as a pull-down resistor.

In an embodiment, the pre-driver 111 may control the voltage mode driver 112 by controlling the states of the pull-up switches SU11, SU12, and SU13 and the pull-down switches SD11, SD12, and SD13 to an open state or a closed state, based on the data to be transmitted to the transceiver 210, i.e., the first data D1.

In the drawings of this specification, the pull-up switches SU11, SU12, and SU13 and the pull-down switches SD11, SD12, and SD13 may be omitted from the illustration for convenience of explanation.

The controlling of the switch to the open state by the pre-driver 111 may be referred to as turning off the resistor corresponding to the switch controlled to the open state. Similarly, the controlling of the switch to the closed state by the pre-driver 111 may be referred to as turning on the resistor corresponding to the switch controlled to the closed state.

In an embodiment, the pull-up resistor circuit 112_1 and the pull-down resistor circuit 112_2 of FIG. 3 are illustrated as including three switches and three resistors, respectively, but this is an example and other embodiments may include a different (e.g. larger or smaller) number of switches and resistors.

The current source circuit 113 may include a first current source CS11 and a second current source CS12. The power supply voltage VDD may be applied to one end of the first current source CS11 (e.g. the one end of the first current source CS11 may be configured to receive the power supply voltage VDD), and the other end of the first current source CS11 may be electrically connected to a second node N2. One end of the second current source CS12 may be electrically connected to the second node N2, and the other end of the second current source CS12 may be electrically connected to ground.

In an embodiment, the pre-driver 111 may control the first current source CS1 and the second current source CS2 of the current source circuit 113, based on data to be transmitted to the transceiver 210, i.e., first data D1. For example, the pre-driver 111 may control the current values output from the first current source CS1 and the second current source CS2. Also, for example, the pre-driver 111 may open (e.g. disconnect) the first current source CS1 and the second current source CS2 from the second node N2.

The transceiver 210 may include a pre-driver 211, a voltage mode driver 212, a current source circuit 213, a receiver 214, and a second hybrid resistor RH2.

The voltage mode driver 212 may include a pull-up resistor circuit 212_1 and a pull-down resistor circuit 212_2. The pull-up resistor circuit 212_1 may include a plurality of pull-up resistors RU21, RU22, and RU23 and a plurality of pull-up switches SU21, SU22, and SU23. The pull-down resistor circuit 212_2 may include a plurality of pull-down resistors RD21, RD22, and RD23 and a plurality of pull-down switches SD21, SD22, and SD23. The power supply voltage VDD may be applied to one end of the pull-up resistor circuit 212_1. That is, the one end of the pull-up resistor circuit 212_1 may be connected to a power supply line (e.g. a line configured to provide a power supply voltage VDD). The other end of the pull-up resistor circuit 212_1 may be electrically connected to a first node N1'. One end of the pull-down resistor circuit 212_2 may be electrically connected to the first node N1'. The other end of the pull-down resistor circuit 212_2 may be electrically connected to the ground.

In an embodiment, the pre-driver 211 may control the voltage mode driver 212 by changing the states of the pull-up switches SU21, SU22, and SU23 and the pull-down switches S211, SD22, and SD23 to an open state or a closed state, based on the data to be transmitted to the transceiver 110, i.e., the second data D2.

The current source circuit 213 may include a first current source CS21 and a second current source CS22. The power supply voltage VDD may be applied to one end of the first current source CS21 (e.g. the one end of the first current source CS21 may be configured to receive the power supply voltage VDD), and the other end of the first current source CS21 may be electrically connected to a second node N2'. One end of the second current source CS22 may be electrically connected to the second node N2', and the other end of the second current source CS22 may be electrically connected to ground.

In an embodiment, the pre-driver 211 may control the first current source CS21 and the second current source CS22 of the current source circuit 213, based on the data to be transmitted to the transceiver 110, i.e., the second data D2. For example, the pre-driver 211 may control the current values output from the first current source CS21 and the second current source CS22. Also, for example, the pre-driver 211 may open (e.g. disconnect) the first current source CS21 and the second current source CS22 from the second node N2'.

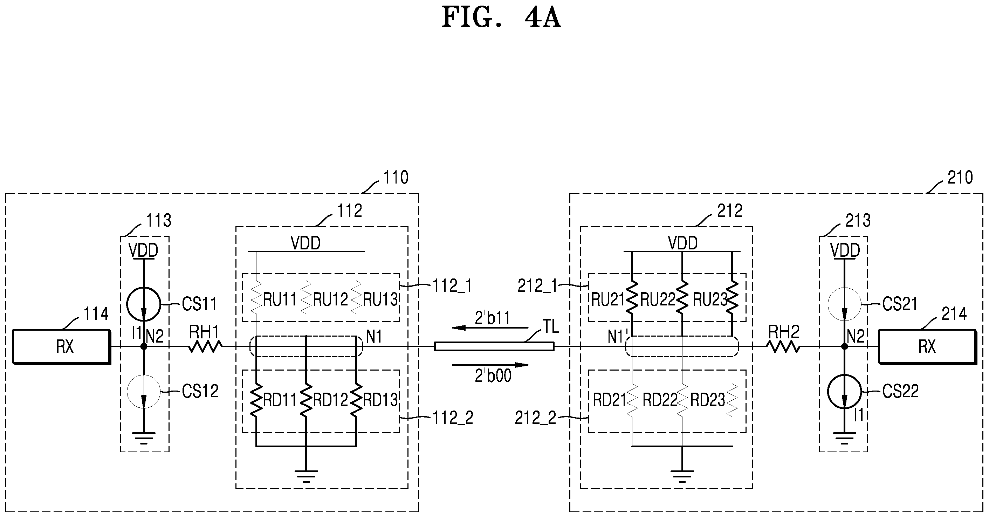

FIG. 4A to 4D are circuit diagrams showing a transceiver according to an embodiment. FIGS. 4A to 4D will be described with reference to FIGS. 1 to 3, and the description already given may be omitted. Below, the operation of the transceiver 110 of the first device 100 is mainly described, and the pre-driver 111, the pull-up switches SU11, SU12, SU13, SU21, SU22, and SU23 and the pull-down switches SD11, SD12, SD13, SD21, SD22, and SD23 of FIG. 3 are omitted from illustration for convenience of explanation.

In the figures of this specification, a section of a circuit diagram that is marked with a relatively faint solid line may indicate that the section is open or inactive and does not affect other components on the circuit diagram.

FIG. 4A is a diagram for explaining a case where the first data D1 is a first value 2'b00 and the second data D2 is the fourth value 2'b11.

Referring to FIG. 4A, when the first data D1 is the first value 2'b00, the pre-driver 111 (in FIG. 3) may electrically open (e.g. disconnect) the pull-up resistor circuit 112_1 from the first node N1 by controlling the pull-up switches SU11, SU12, and SU13 of FIG. 3 to the open (e.g. disconnected) state. In this regard, no current may flow between the two terminals of the pull-up resistor circuit 112_1.

When the first data D1 is the first value 2'b00, the pre-driver 111 may cause the first current source CS11 to generate current and open (e.g. disconnect) the second current source CS12 from the second node N2. The magnitude of the current generated by the first current source CS11 may be a first current value I1.

When the first data D2 is the fourth value 2'b11, the pre-driver 211 (in FIG. 3) may electrically open (e.g. disconnect) the pull-down resistor circuit 112_2 from the first node N1' by controlling the pull-down switches SD21, SD22, and SD23 of FIG. 3 to the open (e.g. disconnected) state. In this regard, no current may flow between the two terminals of the pull-down resistor circuit 212_2.

When the second data D2 is the fourth value 2'b11, the pre-driver 211 may cause the second current source CS22 to generate current and open (e.g. disconnect) the first current source CS21 from a second node N2'. The magnitude of the current generated by the second current source CS22 may be the first current value I1.

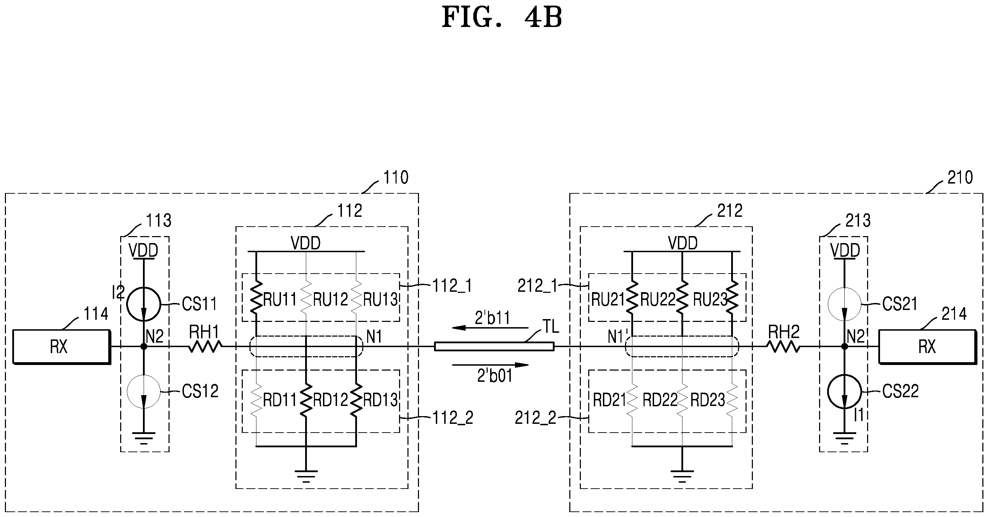

FIG. 4B is a diagram for explaining a case where the first data D1 is the second value 2'b01 and the second data D2 is the fourth value 2'b11.

Referring to FIG. 4B, when the first data D1 is a second value 2'b01, the pre-driver 111 may electrically open (e.g. disconnect) all but one of the pull-up resistors RU11, RU12, and RU13 from the first node N1 by controlling the pull-up switches SU11, SU12, and SU13. For example, the first pull-up resistor RU11 may be electrically connected to the first node N1, and the second pull-up resistor RU12 and the third pull-up resistor RU13 may be electrically opened (e.g. disconnected) from the first node N1. In this regard, no current may flow between the two terminals of the second pull-up resistor RU12 and the two terminals of the third pull-up resistor RU13.

Additionally, the pre-driver 111 may electrically open (e.g. disconnect) one of the pull-down resistors RD11, RD12, and RD13 from the first node N1 by controlling the pull-down switches SD11, SD12, and SD13. For example, the first pull-down resistor RD11 may be electrically opened (e.g. disconnected) from the first node N1, and the second pull-down resistor RD12 and the third pull-down resistor RD13 may be electrically connected to the first node N1. In this regard, no current may flow between the two terminals of the first pull-down resistor RD11.

When the first data D1 is the second value 2'b01, the pre-driver 111 may cause the first current source CS11 to generate current and open (e.g. disconnect) the second current source CS12 from the second node N2. The magnitude of the current generated by the first current source CS11 may be the second current value I2.

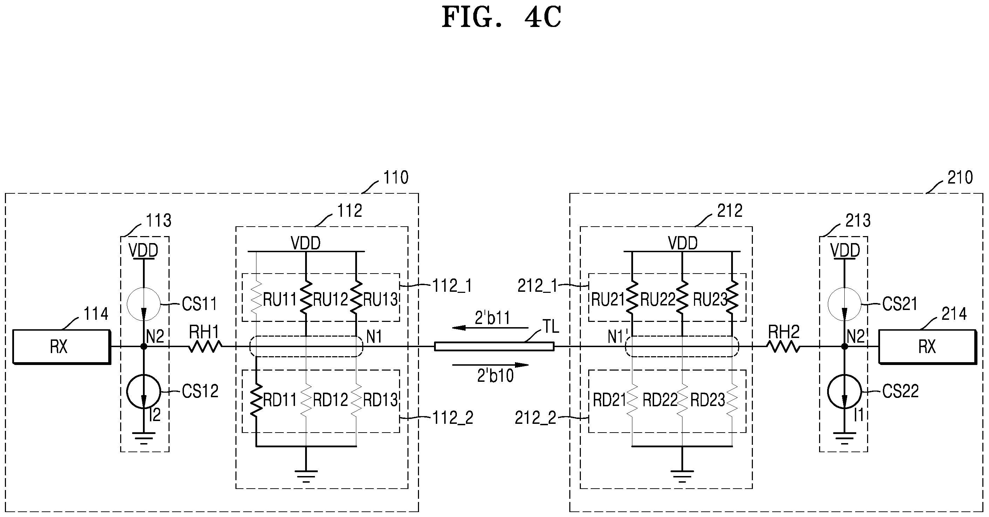

FIG. 4C is a diagram for explaining a case where the first data D1 is the third value 2'b10 and the second data D2 is the fourth value 2'b11.

Referring to FIG. 4C, when the first data D1 is the third value 2'b10, the pre-driver 111 may electrically open (e.g. disconnect) one of the pull-up resistors RU11, RU12, and RU13 from the first node N1 by controlling the pull-up switches SU11, SU12, and SU13. For example, the first pull-up resistor RU11 may be electrically opened (e.g. disconnected) from the first node N1, and the second pull-up resistor RU12 and the third pull-up resistor RU13 may be electrically connected to the first node N1. In this regard, no current may flow between the two terminals of the first pull-up resistor RU11.

In addition, the pre-driver 111 may electrically open (e.g. disconnect) all but one of the pull-down resistors RD11, RD12, and RD13 from the first node N1 by controlling the pull-down switches SD11, SD12, and SD13. For example, the first pull-down resistor RD11 may be electrically connected to the first node N1, and the second pull-down resistor RD12 and the third pull-down resistor RD13 may be electrically opened (e.g. disconnected) from the first node N1. In this regard, no current may flow between the two terminals of the second pull-down resistor RD12 and the third pull-down resistor RD13.

When the first data D1 is the third value 2'b10, the pre-driver 111 may cause the second current source CS12 to generate current and open (e.g. disconnect) the first current source CS11 from the second node N2. The magnitude of the current generated by the second current source CS12 may be the second current value I2.

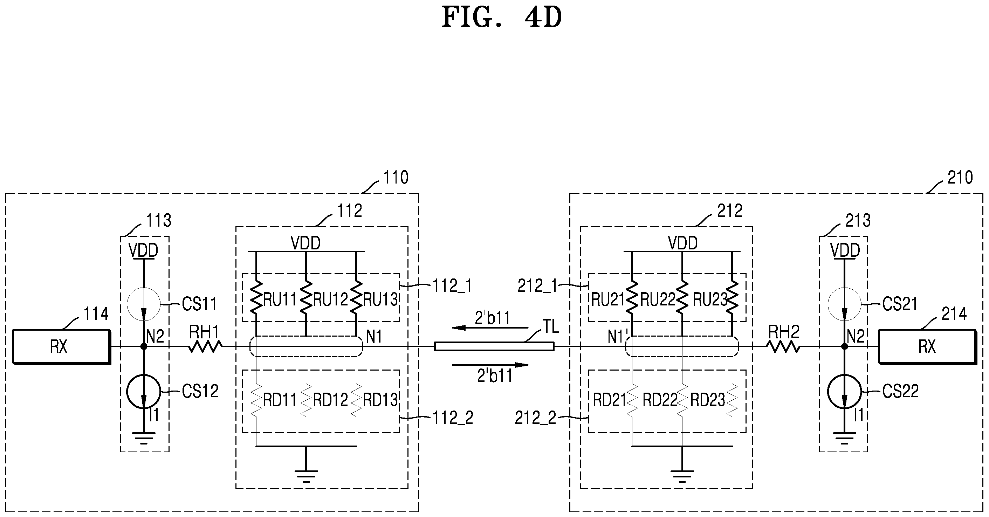

FIG. 4D is a diagram for explaining a case where the first data D1 is the fourth value 2'b11 and the second data D2 is the fourth value 2'b11.

Referring to FIG. 4D, when the first data D1 is the fourth value 2'b11, the pre-driver 111 may electrically open (e.g. disconnect) the pull-down resistor circuit 112_2 from the first node N1 by turning the pull-down switches SD11, SD12, and SD13 to the open (e.g. disconnected) state. In this regard, current may not flow from the pull-down resistor circuit 112_2 to the first node N1.

When the first data D1 is the fourth value 2'b11, the pre-driver 111 may cause the second current source CS12 to generate current and open (e.g. disconnect) the first current source CS11 from the second node N2. The magnitude of the current generated by the second current source CS12 may be the first current value I1.

Referring to FIG. 4A to 4D, the first current value I1 may be larger than the second current value. For instance, the first current value I1 may correspond to three times the second current value I2. For example, when the second current value I2 is 0.5 mA, the first current value I1 may be 1.5 mA. The second current value I2 may correspond to the reference current value. The first current value I1 may correspond to three times the reference current value. In this specification, the reference current value may indicate the magnitude of the reference current.

In an embodiment, when the calibration circuit 120 calibrates the current output by the current source circuit 113, the reference current value may change. This is explained below with reference to FIG. 5. According to the disclosed embodiments of FIGS. 4A to 4D, the voltage level corresponding to the second node N2 may be a voltage level from which the influence due to the first data D1 is removed. The receiver 114 may obtain second data D2 provided from the transceiver 210 by decoding the voltage level of the second node N2.

FIG. 5 is a circuit diagram showing a calibration circuit 120 according to an embodiment. FIG. 5 will be described with reference to FIGS. 1 and 2, and descriptions already given may be omitted.

Referring to FIG. 5, the calibration circuit 120 may include a first comparator CP1, a second comparator CP2, a third comparator CP3, a first replica resistor circuit 121, a first replica current source circuit 122, a first replica hybrid resistor RRH1, a second replica resistor circuit 123, a second replica current source circuit 124, and a second replica hybrid resistor RRH2.

In addition, the calibration circuit 120 may be electrically connected to a first external resistor RE1 via a first ZQ pin ZQ_P. The first ZQ pin ZQ_P may be electrically connected to the first node RN1.

The first replica resistor circuit 121 and the second replica resistor circuit 123 may have the same structure as the voltage mode driver 112 of the transceiver 110. In this regard, the first replica resistor circuit 121 may be a replica of (e.g. may have the same structure of, or may be a copy of) the voltage mode driver 112 of the transceiver 110. Similarly, the second replica resistor circuit 123 may be a replica of (e.g. may have the same structure of, or may be a copy of) the voltage mode driver 112 of the transceiver 110. When an error occurs in the resistors that make up the first replica resistor circuit 121 due to a problem in the semiconductor production process, an error may also occur in the resistors that make up the voltage mode driver 112. The calibration circuit 120 may calibrate the resistors constituting the voltage mode driver 112, based on the driver calibration signal VD_CAL obtained by calibrating the first replica resistor circuit 121. Similarly, the first replica current source circuit 122 and the second replica current source circuit 124 may have the same structure as the current source circuit 113 of the transceiver 110. In this regard, the first replica current source circuit 122 may be a replica of (e.g. may have the same structure of, or may be a copy of) the current source circuit 113 of the transceiver 110. Similarly, second replica current source circuit 124 may be a replica of (e.g. may have the same structure of, or may be a copy of) the current source circuit 113 of the transceiver 110. In addition, the first replica hybrid resistor RRH1 and the second replica hybrid resistor RRH2 may have the same resistance value as the first hybrid resistor RH1 of the transceiver 110. In this regard, the first replica hybrid resistor RRH1 may be a replica of (e.g. may have the same structure of, or may be a copy of) the first hybrid resistor RH1 of the transceiver 110. Similarly, the second replica hybrid resistor RRH2 may be a replica of (e.g. may have the same structure of, or may be a copy of) the first hybrid resistor RH1 of the transceiver 110.

The first replica resistor circuit 121 may include a first replica pull-up resistor circuit 121_1 and a first replica pull-down resistor circuit 121_2.

The first replica pull-up resistor circuit 121_1 may include pull-up resistors RRU11, RRU12, and RRU13. The power supply voltage VDD may be applied to one end of the first replica pull-up resistor circuit 121_1. That is, the one end of the first replica pull-up resistor circuit 121_1 may be connected to a power supply line (e.g. a line configured to provide a power supply voltage VDD). The other end of the first replica pull-up resistor circuit 121_1 may be electrically connected to the first node RN1.

The first replica pull-down resistor circuit 121_2 may include pull-down resistors RRD11, RRD12, and RRD13. One end of the first replica pull-down resistor circuit 121_2 may be electrically connected to the first node RN1, and the other end of the first replica pull-down resistor circuit 121_2 may be electrically connected to ground.

One end of the first replica hybrid resistor RRH1 may be electrically connected to the first node RN1, and the other end of the first replica hybrid resistor RRH1 may be electrically connected to a second node RN2.

The first replica current source circuit 122 may include a first replica current source CSR11 and a second replica current source CSR12.

One end of the first replica current source CSR11 may be supplied with the power supply voltage VDD (e.g. the one end of the first replica current source CSR11 may be configured to receive the power supply voltage VDD), and the other end of the first replica current source CSR11 may be electrically connected to the second node RN2. One end of the second replica current source CSR12 may be electrically connected to the second node RN2, and the other end of the second replica current source CSR12 may be electrically connected to ground.

The second replica resistor circuit 123 may include a second replica pull-up resistor circuit 123_1 and a second replica pull-down resistor circuit 123_2.

The second replica pull-up resistor circuit 123_1 may include pull-up resistors RRU21, RRU22, and RRU23. The power supply voltage VDD may be applied to one end of the second replica pull-up resistor circuit 123_1. That is, the one end of the second replica pull-up resistor circuit 123_1 may be connected to a power supply line (e.g. a line configured to provide a power supply voltage VDD). The other end of the second replica pull-up resistor circuit 123_1 may be electrically connected to a third node RN3.

The second replica pull-down resistor circuit 123_2 may include pull-down resistors RRD21, RRD22, and RRD23. One end of the second replica pull-down resistor circuit 123_2 may be electrically connected to the third node RN3, and the other end of the second replica pull-down resistor circuit 123_2 may be electrically connected to ground.

One end of the second replica hybrid resistor RRH2 may be electrically connected to the third node RN3, and the other end of the second replica hybrid resistor RRH2 may be electrically connected to the third node RN3.

The second replica current source circuit 124 may include a first replica current source CSR21 and a second replica current source CSR22.

One end of the first replica current source CSR21 may be supplied with the power supply voltage VDD (e.g. the one end of the first replica current source CSR21 may be configured to receive the power supply voltage VDD), and the other end of the first replica current source CSR21 may be electrically connected to a fourth node RN4. One end of the second replica current source CSR22 may be electrically connected to the fourth node RN4, and the other end of the second replica current source CSR22 may be electrically connected to ground.

A first input terminal of the first comparator CP1 may be electrically connected to the first node RN1, and a first reference voltage VREF1 may be applied to a second input terminal of the first comparator CP1 (e.g. the second input terminal of the first comparator CP1 may be configured to receive the first reference voltage VREF1).

The first comparator CP1 may generate a first calibration signal CAL1, based on the result of comparing the first reference voltage VREF1 with the voltage of the first node RN1 (i.e., based on a difference between the first reference voltage VREF1 and the voltage of the first node RN1), and may calibrate the first replica resistor circuit 121 and the second replica resistor circuit 123 through the first calibration signal CAL1.

In an embodiment, when the first reference voltage VREF1 is 0.3 V, the first comparator CP1 may calibrate the first replica resistor circuit 121 and the second replica resistor circuit 123 by generating the first calibration signal CAL1. The first comparator CP1 may calibrate the first replica resistor circuit 121 by generating the first calibration signal CAL1 so that the voltage level of the first node RN1 is 0.3 V. The first reference voltage VREF1 being 0.3 V is an example, and a voltage value less than 0.3 V or greater than 0.3 V may be set.

A first input terminal of the second comparator CP2 may be electrically connected to the third node RN3, and the first reference voltage VREF1 may be applied to a second input terminal of the second comparator CP2 (e.g. the second input terminal of the second comparator CP2 may be configured to receive the first reference voltage VREF1).

The second comparator CP2 may generate a second calibration signal CAL2, based on the result of comparing the first reference voltage VREF1 with the voltage of the third node RN3 (i.e., based on a difference between the first reference voltage VREF1 and the voltage of the third node RN3), and may calibrate the second replica resistor circuit 123 through the second calibration signal CAL2.

In an embodiment, when the first reference voltage VREF1 is 0.3 V, the second comparator CP2 may calibrate the second replica resistor circuit 123 by generating the second calibration signal CAL2 so that the voltage level of the third node RN3 is 0.3 V. The first reference voltage VREF1 being 0.3 V is an example, and a voltage value less than 0.3 V or greater than 0.3 V may be set.

In light of the above, the first comparator CP1 and the second comparator CP2 may calibrate the first replica resistor circuit 121 and the second replica resistor circuit 123 such that the voltage levels of both the first node RN1 and the third node RN3 are equal to the first reference voltage VREF1.

The calibration circuit 120 may generate the driver calibration signal VD_CAL. The driver calibration signal VD_CAL may be a signal generated based on the first calibration signal CAL1 and the second calibration signal CAL2. The calibration circuit 120 may calibrate errors in resistance values generated in resistors included in the pull-up resistor circuit 112_1 and the pull-down resistor circuit 112_2 by calibrating the voltage mode driver 112 through the driver calibration signal VD_CAL.

The first input terminal of the third comparator CP3 may be electrically connected to the second node RN2. A second reference voltage VREF2 may be applied to the second input terminal of the third comparator CP3 (e.g. the second input terminal of the third comparator CP3 may be configured to receive the second reference voltage VREF2). When the voltage level of the second node RN2 does not match the voltage level of the second reference voltage VREF2, the third comparator CP3 may adjust the voltage level of the second node RN2 to the voltage level of the second reference voltage VREF2 by adjusting the current generated by the first replica current source circuit 122 through a third calibration signal CAL3.

The calibration circuit 120 may generate a current source circuit calibration signal CS_CAL. The current source circuit calibration signal CS_CAL may be a signal generated based on the third calibration signal CAL3. By calibrating the current source circuit 113 through the current source circuit calibration signal CS_CAL, the error in the resistance value generated in the first hybrid resistor RH1 may be calibrated. In an embodiment, the calibration circuit 120 may calibrate the current output by the current source circuit 113 by adjusting the reference current value output by the current source circuit 113.

For example, it is assumed that the reference current value before calibration is 0.5 mA and the reference current value after calibration is 0.58 mA. In this case, the first current value I1 after calibration may be 1.74 mA, and the second current value I2 after calibration may be 0.58 mA. The calibration circuit 220 of the second device 200 may also have the same configuration as the calibration circuit 120 of the first device 100, and the description already given is omitted.

In an embodiment, the first reference voltage VREF1 may be half of the power supply voltage VDD. The second reference voltage VREF2 may be half of the first reference voltage VREF1 (e.g. a quarter of the power supply voltage VDD).

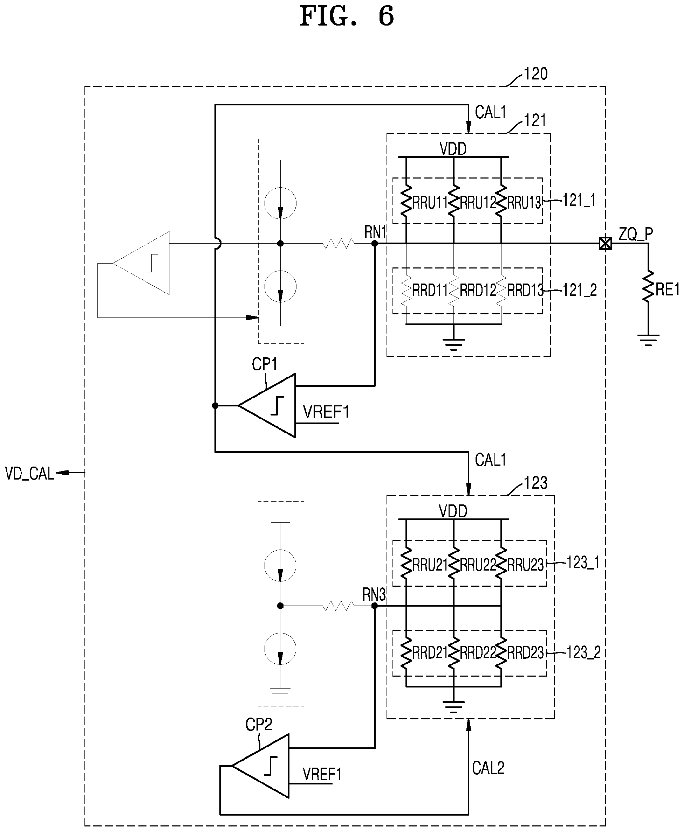

FIG. 6 is a circuit diagram showing a calibration circuit 120 according to an embodiment. In detail, FIG. 6 is a drawing for explaining that the calibration circuit 120 of FIG. 5 generates a driver calibration signal VD_CAL. FIG. 6 will be described with reference to FIG. 5, and descriptions already given may be omitted.

Referring to FIG. 6, for convenience of explanation, circuit configurations that are not related to generating the driver calibration signal VD_CAL are depicted in relatively faint solid lines.

In an embodiment, each of the pull-up resistors RU11, RU12, RU13, RU21, RU22, and RU23, the pull-down resistors RD11, RD12, RD13, RD21, RD22, and RD23 of FIG. 3, the replica pull-up resistors RRU11, RRU12, RRU13, RRU21, RRU22, and RRU23, and the replica pull-down resistors RRD11, RRD12, RRD13, RRD21, RRD22, and RRD23 of FIG. 5 may be implemented through multiple transistors. For instance, each resistor (e.g. each of the pull-up resistors RU11, RU12, RU13, RU21, RU22, and RU23, the pull-down resistors RD11, RD12, RD13, RD21, RD22, and RD23 of FIG. 3, the replica pull-up resistors RRU11, RRU12, RRU13, RRU21, RRU22, and RRU23, and the replica pull-down resistors RRD11, RRD12, RRD13, RRD21, RRD22, and RRD23 of FIG. 5 may be a resistor unit having variable resistance according to a calibration signal. In this specification, calibrating a resistance circuit by a calibration circuit 120 may indicate adjusting a resistance value by turning on or off a plurality of transistors constituting each resistor. For instance, calibrating a resistance circuit by a calibration circuit 120 may indicate adjusting a resistance value of at least one (e.g. each) resistor unit in the resistance circuit.

In FIG. 6, it is assumed that an error occurs in each resistor. For example, when designing the first device 100 (in FIG. 1), the resistance value of each resistor may be designed to be 150 Ω, but it is assumed that the value is not 150 Ω due to the PVT variation.

The calibration circuit 120 may calibrate the first replica pull-up resistor circuit 121_1 and the second replica pull-up resistor circuit 123_1 of the first replica resistor circuit 121 through the first calibration signal CAL1, and may calibrate the second replica pull-down resistor circuit 123_2 through the second calibration signal CAL2.

The calibration circuit 120 may open (e.g. disconnect) the first replica pull-down resistor circuit 121_2 from the first node RN1. The calibration circuit 120 may generate the first calibration signal CAL1, based on the result of comparing the voltage of the first node RN1 with the first reference voltage VREF1 (i.e., based on a difference between the voltage of the first node RN1 and the first reference voltage VREF1). The first calibration signal CAL1 may turn on or off a plurality of transistors constituting the resistors included in the first replica pull-up resistor circuit 121_1 so that the voltage of the first node RN1 becomes (e.g. matches) the first reference voltage VREF1. By turning on or off multiple transistors constituting the resistors, the value indicated by each resistor of the first replica pull-up resistor circuit 121_1 may be calibrated. For example, the value may be calibrated to 150 Ω.

The calibration circuit 120 may calibrate the error of the second replica pull-up resistor circuit 123_1, based on the calibration of the first replica pull-up resistor circuit 121_1.

The calibration circuit 120 may generate a second calibration signal CAL2, based on the result of comparing the voltage of the third node RN3 with the first reference voltage VREF1 (i.e., based on a difference between the voltage of the third node RN3 and the first reference voltage VREF1). The second calibration signal CAL2 may turn on or off a plurality of transistors constituting the resistors included in the second replica pull-down resistor circuit 123_2 so that the voltage of the third node RN3 becomes (e.g. matches) the first reference voltage VREF1. By turning on or off the plurality of transistors constituting the resistors, the value indicated by each resistor of the second replica pull-down resistor circuit 123_2 may be calibrated. For example, the value may be calibrated to 150 Ω.

The calibration circuit 120 may generate a driver calibration signal VD_CAL, based on the first calibration signal CAL1 and the second calibration signal CAL2. The driver calibration signal VD_CAL may be a signal that includes the first calibration signal CAL1 and the second calibration signal CAL2. Alternatively, the first calibration signal CAL1 and the second calibration signal CAL2 may each be signals output from the calibration circuit 120 as the driver calibration signal VD_CAL.

In an embodiment, the first calibration signal CAL1 may be provided to the voltage mode driver 112 as the driver calibration signal VD_CAL, thus allowing the resistance values of the resistors in the pull-up resistor circuit 112_1 constituting the voltage mode driver 112 to be calibrated. For example, suppose the first calibration signal CAL1 is a signal that turns off at least one of the transistors and turns on the remaining transistors among the plurality of transistors constituting the replica pull-up resistor RRU11 in the first replica pull-up resistor circuit 121_1, and also turns off at least one of the transistors and turns on the remaining transistors among the plurality of transistors constituting the replica pull-up resistor RRU21 in the second replica pull-up resistor circuit 123_1. The replica pull-up resistor RRU11 may correspond to the replica pull-up resistor RRU21, and both the replica pull-up resistor RRU11 and the replica pull-up resistor RRU21 may each correspond to the pull-up resistor RU11. The first calibration signal CAL1 may be provided to the voltage mode driver 112 as the driver calibration signal VD_CAL, turning off at least one transistor and turning on the remaining transistors among the plurality of transistors constituting the pull-up resistor RU11. In this case, the number of transistors turned on in the replica pull-up resistors RRU11 and RRU21 may be the same as the number of transistors turned on in the pull-up resistor RU11. Likewise, the number of transistors turned off in the replica pull-up resistors RRU11 and RRU21 may be the same as the number of transistors turned off in the pull-up resistor RU11.

In an embodiment, the second calibration signal CAL2 may be provided to the voltage mode driver 112 as the driver calibration signal VD_CAL, thus allowing the resistance values of the resistors in the pull-down resistor circuit 112_2 constituting the voltage mode driver 112 to be calibrated. For example, suppose the second calibration signal CAL2 is a signal that turns off at least one of the transistors and turns on the remaining transistors among the plurality of transistors constituting the replica pull-down resistor RRD21 in the second replica pull-down resistor circuit 123_2. The replica pull-down resistor RRD21 may correspond to the pull-down resistor RD11. The second calibration signal CAL2 may be provided to the voltage mode driver 112 as the driver calibration signal VD_CAL, turning off at least one transistor and turning on the remaining transistors among the plurality of transistors constituting the pull-down resistor RD11. In this case, the number of transistors turned on in the replica pull-down resistor RRD21 may be the same as the number of transistors turned on in the pull-down resistor RD11. Likewise, the number of transistors turned off in the replica pull-down resistor RRD21 may be the same as the number of transistors turned off in the pull-down resistor RD11.

FIG. 7 is a circuit diagram showing a calibration circuit 120 according to an embodiment. In detail, FIG. 7 is a diagram for explaining that the calibration circuit 120 of FIG. 5 generates a current source circuit calibration signal CS_CAL. FIG. 7 will be explained with reference to FIG. 5, and descriptions already given may be omitted.

Referring to FIG. 7, for convenience of explanation, circuit configurations that are not related to generating the current source circuit calibration signal CS_CAL are depicted in relatively faint solid lines.

In FIG. 7, it is assumed that each resistor included in the first replica resistor circuit 121 is calibrated to the intended value (e.g., 150 Ω) during design. It is assumed that an error has occurred in the first replica hybrid resistor RRH1. For example, it is assumed that the intended resistance value of the first replica hybrid resistor RRH1 is 75 Ω when designed, but the resistance value appears as 60 Ω due to PVT variation.

The calibration circuit 120 may calibrate the error of the first replica hybrid resistor RRH1 by controlling the current of the first replica current source circuit 122. That is, by controlling the current of the first replica current source circuit 122, the error in the voltage level of the second node RN2 caused by the error of the first replica hybrid resistor RRH1 is calibrated.

The calibration circuit 120 may open (e.g. disconnect) any one of the resistors included in the first replica pull-up resistor circuit 121_1 from the first node RN1. For example, the replica pull-up resistor RRU13 may be opened (e.g. disconnected) from the first node RN1. The calibration circuit 120 may open (e.g. disconnect) all but one of the resistors included in the first replica pull-down resistor circuit 121_2 from the first node RN1. For example, the replica pull-down resistor RRD11 and the replica pull-down resistor RRD12 may be opened (disconnected) from the first node RN1.

A second reference voltage VREF2 may be applied to the second input terminal of the third comparator CP3. In an embodiment, the voltage of the second reference voltage VREF2 may be 1/4 VDD. In this case, the third comparator CP3 may control the first replica current source circuit 122 through the third calibration signal CAL3 so that the voltage of the second node RN2 becomes (e.g. matches) the second reference voltage VREF2. In an embodiment, the first replica current source CSR11 may be opened (e.g. disconnected), and the current output by the second replica current source CSR12 may be regulated based on the third comparator CP3. When the voltage of the second node RN2 becomes (e.g. matches) the second reference voltage VREF2, the current output by the second current source CSR12 may represent the calibration current ICAL.

The calibration circuit 120 may generate the current source circuit calibration signal CS_CAL, which is a signal for calibrating the reference current of the current source circuit 113. In an embodiment, the third calibration signal CAL3 may be output from the calibration circuit 120 as the current source circuit calibration signal CS_CAL. The magnitude of the calibration current ICAL may correspond to the reference current value of the current source circuit 113. The current source circuit calibration signal CS_CAL may be a signal that adjusts the reference current value of the current source circuit 113 to the magnitude of a calibration current ICAL. For example, when the calibrated current ICAL is 0.58 mA, the current source circuit calibration signal CS_CAL calibrates the current source circuit 113 so that the first current value I1 (in FIGS. 4A to 4D) (e.g. three times the reference current value) after calibration becomes 1.74 mA, and the second current value I2 (in FIGS. 4A to 4D) after calibration (e.g. the same as the reference current value) becomes 0.58 mA.

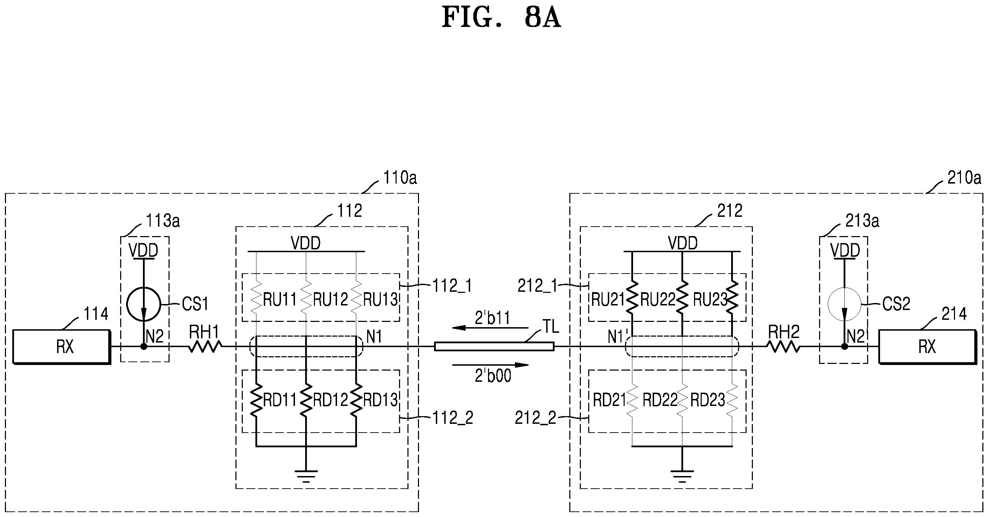

FIGS. 8A to 8D are circuit diagrams showing a transceiver according to an embodiment. In detail, FIGS. 8A to 8D are drawings for explaining an embodiment in which the configuration of the current source circuits 113a and 213a is different from the configuration of the current source circuits 113 and 213 in FIGS. 4A to 4D. FIGS. 8A to 8D will be described with reference to FIGS. 1 and 4A, and descriptions already given may be omitted. The description of FIGS. 8A to 8D focuses on the differences from FIGS. 4A to 4D.

Referring to FIGS. 8A to 8D, the transceiver 110a of FIGS. 8A to 8D may correspond to the transceiver 110 of FIGS. 4A to 4D, and the transceiver 210 of FIGS. 8A to 8D may correspond to the transceiver 210 of FIGS. 4A to 4D.

However, unlike the current source circuits 113 and 213 of FIGS. 4A to 4D, the current source circuits 113a and 213a of FIGS. 8A to 8D may not have a current source electrically connected between the second node N2 and the ground. That is, the current source circuits 113a and 213a of FIGS. 8A to 8D may each include current sources CS1 and CS2 to which a power supply voltage VDD is applied at one end (e.g. one end configured to receive the power supply voltage VDD) and of which other end is electrically connected to a second node N2.

Based on the value of the first data D1, the magnitude of the current provided by the current source circuit 113a to the second node N2 may change. Similarly, based on the value of the second data D2, the magnitude of the current provided by the current source circuit 213a to the second node N2' may change.

FIG. 8A is a diagram for explaining a case where the first data D1 is a first value 2'b00 and the second data D2 is a fourth value 2'b11.

Referring to FIG. 8A, when the first data D1 is the first value 2'b00, the magnitude of the current generated by the first current source CS1 may correspond to three times the magnitude of the reference current. In an embodiment, the reference current magnitude may be 0.5 mA, and when the first data D1 is the first value 2'b00, the magnitude of the current generated by the first current source CS1 may be 1.5 mA.

When the second data D2 is the fourth value 2'b11, the second current source CS2 may not generate current. That is, the second current source CS2 may be opened (e.g. disconnected) from the second node N2'. In an embodiment, the reference current magnitude may be 0.5 mA, and when the second data D2 is the fourth value 2'b11, the magnitude of the current generated by the second current source CS2 may be 0 mA.

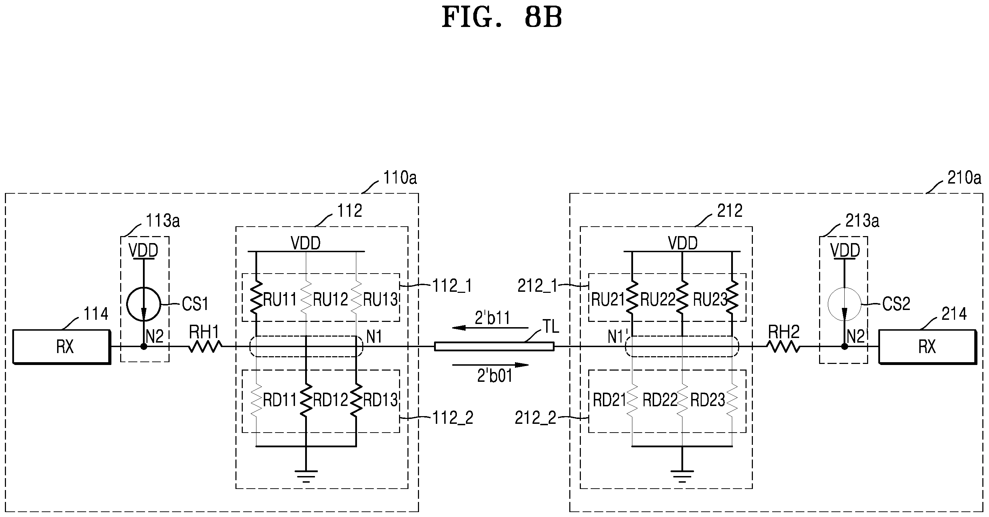

FIG. 8B is a drawing for explaining a case where the first data D1 is the second value 2'b01 and the second data D2 is the fourth value 2'b11.

Referring to FIG. 8B, when the first data D1 is the second value 2'b01, the magnitude of the current generated by the first current source CS1 may correspond to twice the magnitude of the reference current. In an embodiment, the reference current magnitude may be 0.5 mA, and when the first data D1 is the second value 2'b01, the magnitude of the current generated by the first current source CS1 may be 1.0 mA.

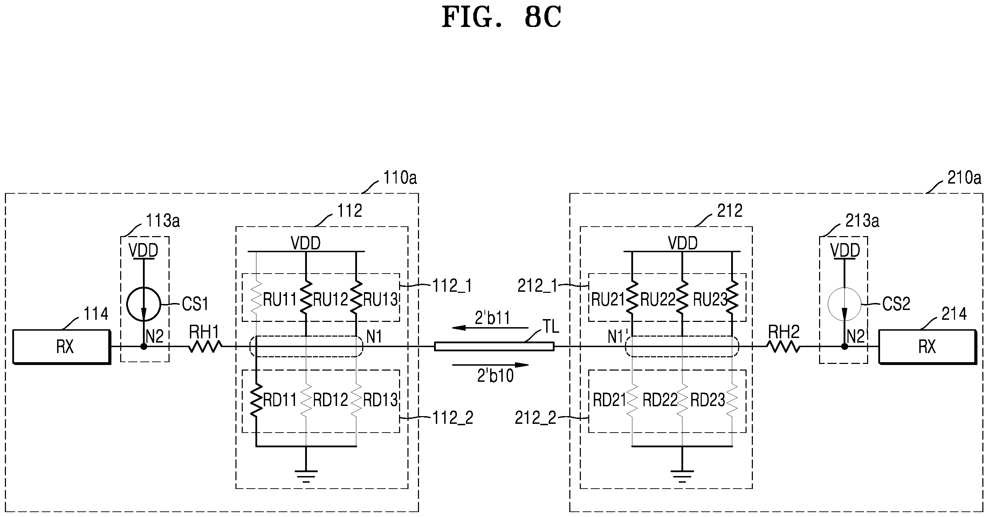

FIG. 8C is a diagram for explaining a case where the first data D1 is a third value 2'b10 and the second data D2 is a fourth value 2'b11.

Referring to FIG. 8C, when the first data D1 is the third value 2'b10, the magnitude of the current generated by the first current source CS1 may correspond to one times (e.g. may equal) the magnitude of the reference current. In an embodiment, the reference current magnitude may be 0.5 mA, and when the first data D1 is the third value 2'b10, the magnitude of the current generated by the first current source CS1 may be 0.5 mA.

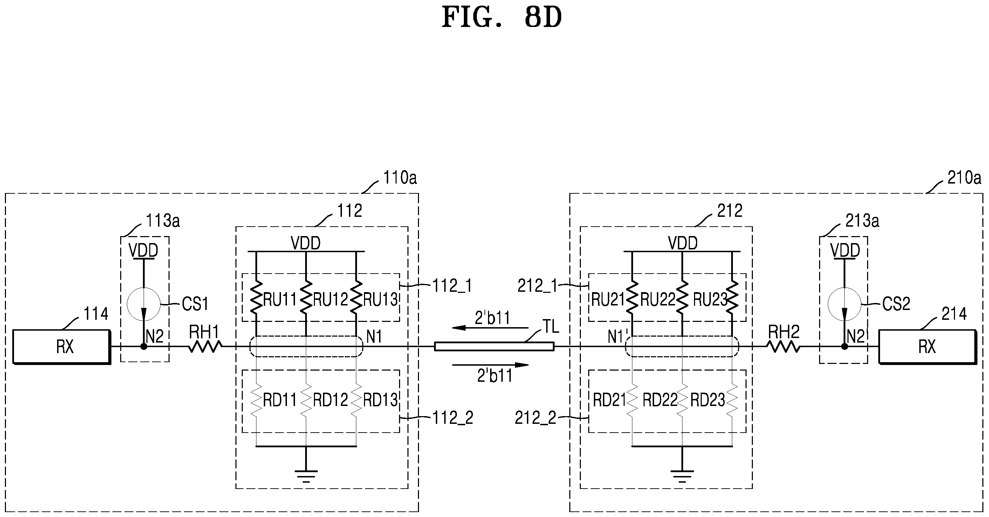

FIG. 8D is a diagram for explaining a case where the first data D1 is the fourth value 2'b11 and the second data D2 is the fourth value 2'b11.

Referring to FIG. 8D, when the first data D1 is the fourth value 2'b11, the first current source CS1 may not generate current. That is, the first current source CS1 may be opened (e.g. disconnected) from the second node N2. In an embodiment, the magnitude of the reference current may be 0.5 mA, and when the first data D1 is the fourth value 2'b11, the magnitude of the current generated by the first current source CS1 may be 0 mA.

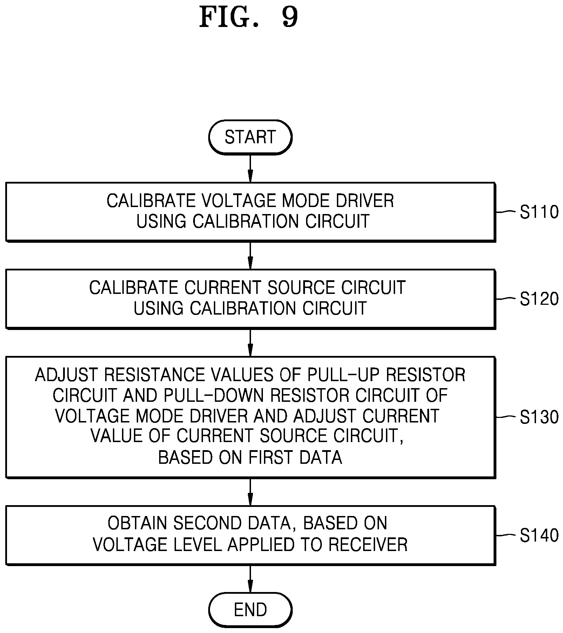

FIG. 9 is a flowchart for explaining an operation method of a device, according to an embodiment. FIG. 9 will be explained with reference to FIGS. 1 to 7, and descriptions already given may be omitted.

In FIG. 9, as shown in FIGS. 4A to 4D, it is assumed and described that the first device 100 transmits the first data D1 to the second device 200, and the first device 100 receives the second data D2 from the second device 200.

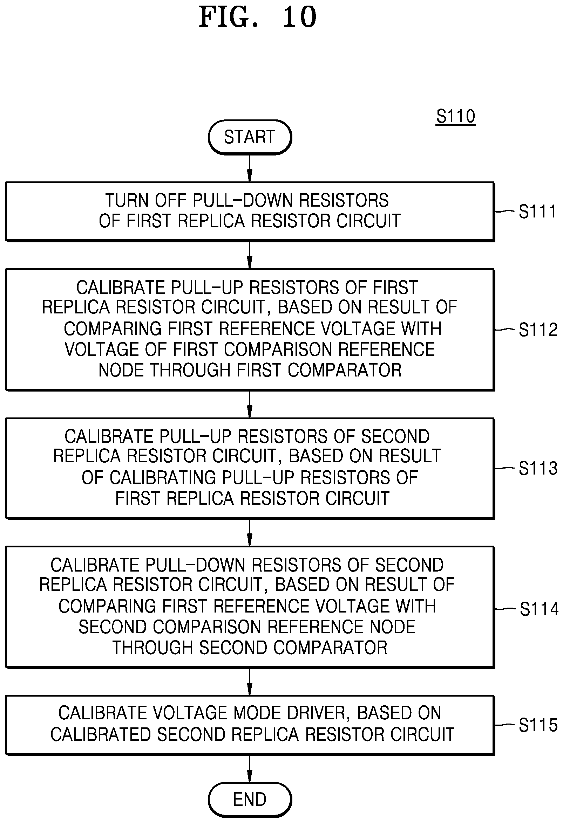

Referring to FIG. 9, in operation S110, the first device 100 may calibrate the voltage mode driver 112 using a calibration circuit 120. The calibration of the voltage mode driver 112 by the first device 100 may be performed to calibrate (e.g. reduce or remove) an error in the resistance value indicated by each of the plurality of resistors included in the voltage mode driver 112 (i.e., an error due to a PVT variation, etc.) during the production process of the first device 100. A specific description of operation S110 is provided below with reference to FIG. 10.

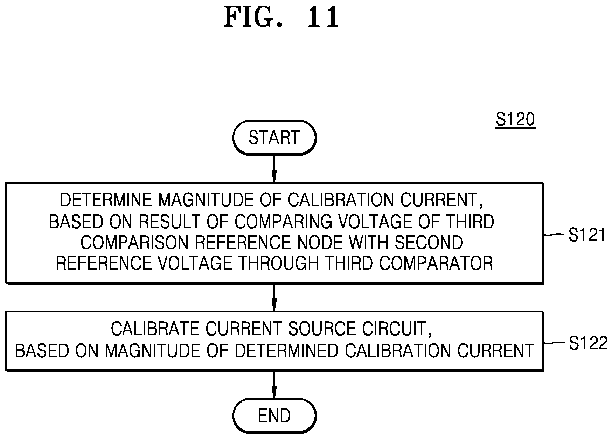

In operation S120, the first device 100 may calibrate the current source circuit 113 using the calibration circuit 120. The first device 100 may calibrate the current source circuit 113 by adjusting the magnitude of the reference current output by the current source circuit 113. A specific description of operation S120 is provided below with reference to FIG. 11.

In operation S130, the first device 100 may adjust the resistance values of the pull-up resistor circuit 112_1 and the pull-down resistor circuit 112_2 of the voltage mode driver 112 and adjust the current value of the current source circuit 113, based on the first data D1.

Based on the first data D1, the adjustment of the resistance values of the pull-up resistor circuit 112_1 and the pull-down resistor circuit 112_2 of the voltage mode driver 112 by the first device 100 may indicate opening (e.g. disconnecting) each of the resistors constituting the pull-up resistor circuit 112_1 and the pull-down resistor circuit 112_2 from the first node N1 or connecting each of the resistors to the first node N1 by controlling the switches corresponding to each of the resistors to the open or closed state.

Likewise, the first device 100 may adjust the current value of the current source circuit 113, based on the first data D1, which may indicate opening (e.g. disconnecting) the current sources constituting the current source circuit 113 from the second node N2 or adjusting the magnitude of the current.

In an embodiment, when the first data D1 is the first value 2'b00, the first device 100 may electrically open (e.g. disconnect) the pull-up resistor circuit 112_1 from the first node N1, and the first device 100 may electrically open (e.g. disconnect) the second current source CS12 from the second node N2.

In an embodiment, when the first data D1 is the second value 2'b01, the first device 100 may electrically open (e.g. disconnect) the remaining pull-up resistors except for one of the pull-up resistors included in the pull-up resistor circuit 112_1 from the first node N1. The first device 100 may electrically open (e.g. disconnect) one of the pull-down resistors included in the pull-down resistor circuit 111_2 from the first node N1. The first device 100 may electrically open (e.g. disconnect) the second current source CS12 from the second node N2. In this case, the resistance value of the pull-up resistor circuit 112_1 may be greater than the resistance value of the pull-down resistor circuit 112_2.

In an embodiment, when the first data D1 is the third value 2'b10, the first device 100 may electrically open (e.g. disconnect) one of the pull-up resistors included in the pull-up resistor circuit 112_1 from the first node N1. The first device 100 may electrically open (e.g. disconnect) the remaining pull-down resistors except for one of the pull-down resistors included in the pull-down resistor circuit 112_2 from the first node N1. The first device 100 may electrically open (e.g. disconnect) the first current source CS11 from the second node N2. In this case, the resistance value of the pull-up resistor circuit 112_1 may be less than the resistance value of the pull-down resistor circuit 112_2.

In an embodiment, when the first data D1 is the fourth value 2'b11, the first device 100 may electrically open (e.g. disconnect) the pull-down resistor circuit 112_2 from the first node N1. The first device 100 may electrically open (e.g. disconnect) the first current source CS11 from the second node N2.

In operation S140, the first device 100 may obtain second data D2, based on the voltage level applied to the input of the receiver 114 (i.e., the voltage level of the second node N2).

In an embodiment, when the voltage level of the second node N2 is a first voltage level, the receiver 114 may obtain the first value 2'b00.

In an embodiment, when the voltage level of the second node N2 is a second voltage level, the receiver 114 may obtain the second value 2'b01. The second voltage level may be greater than the first voltage level.

In an embodiment, when the voltage level of the second node N2 is a third voltage level, the receiver 114 may obtain the third value 2'b10. The third voltage level may be greater than the second voltage level.

In an embodiment, when the voltage level of the second node N2 is a fourth voltage level, the receiver 114 may obtain the fourth value 2'11. The fourth voltage level may be greater than the third voltage level.

FIG. 10 is a flowchart for explaining an operation method of a device, according to an embodiment. FIG. 10 is a flowchart showing operation S110 of FIG. 9 in detail. FIG. 10 will be described with reference to FIGS. 1 to 7 and 9, and descriptions already given may be omitted.

Referring to FIG. 10, in operation S111, the first device 100 may turn off the pull-down resistors RRD11, RRD12, and RRD13 (in FIG. 6) of the first replica resistor circuit 121 (in FIG. 6). In this regard, the first device 100 may open (e.g. disconnect) the pull-down resistors RRD11, RRD12, and RRD13 from the first node RN1 (in FIG. 6).

In an embodiment, turning off the pull-down resistor by the first device 100 may indicate controlling the switches corresponding to each pull-down resistor to be turned off to the open state.

In an embodiment, the first node RN1 may be a node defined by one input terminal of the first comparator CP1, one end of the first replica pull-up resistor circuit 121_1 of the first replica resistor circuit 121, and one end of the first replica pull-down resistor circuit 121_2 of the first replica resistor circuit 121. The first node RN1 may be referred to as a first comparison reference node.

In operation S112, the first device 100 may calibrate the pull-up resistors RRU11, RRU12, and RRU13 of the first replica resistor circuit 121, based on the result of comparing the first reference voltage VREF1 with the voltage of the first node RN1 through the first comparator CP1 (i.e., based on a difference between the first reference voltage VREF1 and the voltage of the first node RN1).

In an embodiment, a signal indicating the calibration value of the pull-up resistors RRU11, RRU12, and RRU13 of the first replica resistor circuit 121 may be a first calibration signal CAL1.

In operation S113, the first device 100 may calibrate the pull-up resistors RRU21, RRU22, and RRU23 of the second replica resistor circuit 123, based on the result of calibrating the pull-up resistors RRU11, RRU12, and RRU13 of the first replica resistor circuit 121.

In an embodiment, the signal representing the calibration value of the pull-up resistors RRU21, RRU22, and RRU23 of the second replica resistor circuit 123 may be the first calibration signal CAL1. That is, the calibration values corresponding to the pull-up resistors RRU11, RRU12, and RRU13 of the first replica resistor circuit 121 may be the same as the calibration values corresponding to the pull-up resistors RRU21, RRU22, and RRU23 of the second replica resistor circuit 123.

In operation S114, the first device 100 may calibrate the pull-down resistors RRD21, RRD22, and RRD23 of the second replica resistor circuit 123, based on the result of comparing the first reference voltage VREF1 with a third node RN3 through the second comparator CP2 (i.e., based on a difference between the first reference voltage VREF1 and the voltage of the third node RN3).

In an embodiment, a signal representing the calibration values of the pull-down resistors RRD21, RRD22, and RRD23 of the second replica resistor circuit 123 may be a second calibration signal CAL2.

In an embodiment, the third node RN3 can be defined by one input terminal of the second comparator, one end of the pull-up resistors of the second replica resistor circuit, and one end of the pull-down resistors of the second replica resistor circuit. The third node RN3 may be referred to as a second comparison reference node.

In operation S115, the first device 100 may calibrate the voltage mode driver 112, based on the calibrated first replica resistor circuit 121 and the calibrated second replica resistor circuit 123.

In detail, the first device 100 may generate a driver calibration signal VD_CAL indicating a calibration value indicated by the first calibration signal CAL1 and a calibration value indicated by the second calibration signal CAL2, and may calibrate a voltage mode driver 112, based on the driver calibration signal VD_CAL.

FIG. 11 is a flowchart for explaining an operation method of a device, according to an embodiment. FIG. 11 is a flowchart illustrating operation S120 of FIG. 9 in detail. FIG. 11 will be described with reference to FIGS. 1 to 7 and 9, and descriptions already given may be omitted.

Referring to FIG. 11, in operation S121, the first device 100 may determine the magnitude of the calibration current ICAL, based on the result of comparing the voltage of the second node RN2 with the second reference voltage VREF2 through the third comparator CP3 (i.e., based on a difference between the voltage of the second node RN2 and the second reference voltage VREF2). The second node RN2 may be referred to as a third comparison reference node.

In an embodiment, the first device 100 may compare the voltage of the second node RN2 with the second reference voltage VREF2 through the third comparator CP3, and the result may be a third calibration signal CAL3. The third calibration signal CAL3 may represent a value for calibrating the magnitude of the current output by the first replica current source circuit 122.

In operation S122, the first device 100 may generate a current source circuit calibration signal CS_CAL, based on the magnitude of the determined calibration current ICAL. The first device 100 may calibrate the current source circuit 113, based on the current source circuit calibration signal CS_CAL.

In an embodiment, the first device 100 may calibrate the current source circuit 113 by calibrating the basic current values of the current sources constituting the current source circuit 113. For instance, each current source may comprise a plurality of current source units, and these may be selectively turned on or off based on the current source circuit calibration signal CS_CAL to adjust the magnitude of the current output by the current source.

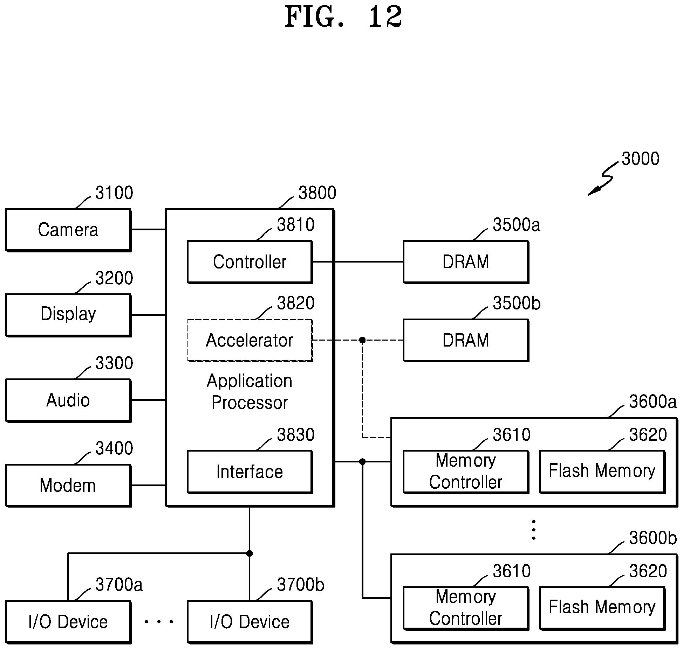

FIG. 12 is a block diagram illustrating a system 3000 including a memory device including a device according to embodiments.

Referring to FIG. 12, the system 3000 may include a camera 3100, a display 3200, an audio processor 3300, a modem 3400, DRAMs 3500a and 3500b, flash memories 3600a and 3600b, I/O devices 3700a and 3700b, and an application processor (AP) 3800. The system 3000 may be implemented as a laptop computer, a mobile phone, a smart phone, a tablet personal computer (PC), a wearable device, a healthcare device, or an internet of things (IoT) device. In addition, the system 3000 may be implemented as a server or a PC.

The camera 3100 may capture still images or videos under the user's control and store the captured image/video data or transmit the captured image/video data to the display 3200. The audio processor 3300 may process audio data included in flash memories 3600a and 3600b or content of a network. The modem 3400 modulates and transmits a signal for wired/wireless data transmission and reception, and may demodulate the signal to restore the modulated signal to the original signal at the receiving end. The I/O devices 3700a and 3700b may include devices providing digital input and/or output capabilities, such as universal serial bus (USB), storage, digital cameras, secure digital (SD) cards, digital versatile discs (DVDs), network adapters, touch screens, etc.

The AP 3800 may control the overall operation of the system 3000. The AP 3800 may control the display 3200 so that a portion of the content stored in the flash memories 3600a and 3600b is displayed on the display 3200. When a user input is received through I/O devices 3700a and 3700b, the AP 3800 may perform a control operation corresponding to the user input. The AP 3800 may include a controller 3810 and an interface 3830, and may include an accelerator block, which is a dedicated circuit for artificial intelligence (AI) data operations, or may have an accelerator chip 3820 separately from the AP 3800. Additionally, the DRAM 3500b may be mounted on the accelerator block or accelerator chip 3820. An accelerator is a functional block that specializes in performing a specific function of the AP 3800. The accelerator may include a graphics processing unit (GPU), a functional block that specializes in performing graphic data processing, a neural processing unit (NPU), a block that specializes in performing AI calculations and inference, and a data processing unit (DPU), a block that specializes in data transmission.

The system 3000 may include the plurality of DRAMs 3500a and 3500b. The AP 3800 may control DRAMs 3500a and 3500b through commands and mode register (MRS) settings that conform to the joint electron device engineering council (JEDEC) standard specifications, or communicate by setting the DRAM interface protocol to use the company's unique functions such as low voltage/high speed/reliability and cyclic redundancy check (CRC)/error correction code (ECC) functions. For example, the AP 3800 may communicate with DRAM 3500a through an interface that complies with JEDEC standard specifications such as LPDDR4 and LPDDR5, and accelerator block or accelerator chip 3820 may communicate by setting a new DRAM interface specification to control accelerator DRAM 3500b having a higher bandwidth than DRAM 3500a.

In FIG. 12, only DRAMs 3500a and 3500b are illustrated, but this is not limited thereto. Any memory, such as PRAM, SRAM, MRAM, RRAM, FRAM, or Hybrid RAM, may be used as long as the memory satisfies the bandwidth, response speed, and voltage conditions of the AP 3800 or the accelerator chip 3820. The DRAMs 3500a and 3500b have relatively lower latency and bandwidth than the I/O devices 3700a and 3700b or the flash memories 3600a and 3600b. The DRAMs 3500a and 3500b may be initialized when the system 3000 is powered on, and may be used as temporary storage locations for operating systems and application data by loading the operating system and application data, or as execution space for various software codes.

In the DRAMs 3500a and 3500b, arithmetic operations such as addition/subtraction/multiplication/division, vector operations, address operations, or fast Fourier transform (FFT) operations may be performed. In addition, within the RAMs 3500a and 3500b, a function for performing inference may be performed. Here, the inference may be performed in deep learning algorithms using artificial neural networks. The deep learning algorithm may include a training stage in which a model is learned through various data, and an inference stage in which data is recognized using the learned model. As an embodiment, the image captured by the user through the camera 3100 may be signal processed and stored in the DRAM 3500b. The accelerator block or accelerator chip 3820 may perform AI data operations that recognize data using the data stored in the DRAM 3500b and the function used for inference.

The system 3000 may include a plurality of storages or a plurality of flash memories 3600a and 3600b having a greater capacity than the DRAMs 3500a and 3500b. The accelerator block or accelerator chip 3820 may perform training operations and AI data operations using flash memories 3600a and 3600b. In an embodiment, the flash memories 3600a and 3600b may more efficiently perform the training operation and inference AI data calculations performed by the AP 3800 and/or the accelerator chip 3820 using the computational device provided in the memory controller 3610. The flash memories 3600a and 3600b may store pictures taken by the camera 3100 or data transmitted through a data network. For example, it may store augmented reality/virtual reality, high definition (HD) or ultra high definition (UHD) content.

The system 3000 may transmit or receive signals for high-speed operation between components. The camera 3100, display 3200, audio processor 3300, modem 3400, DRAMs 3500a and 3500b, flash memories 3600a and 3600b, I/O devices 3700a and 3700b and/or AP 3800 within the system 3000 may include the first device 100 described with reference to FIGS. 1 to 11.

As described above, embodiments have been disclosed in the drawings and specifications. Although specific terms have been used to describe embodiments, the terms have been used only for the purpose of explaining the technical idea of the inventive concept and are not intended to limit the meaning or the scope of the inventive concept set forth in the claims.

While aspects of embodiments have been particularly shown and described, it will be understood that various changes in form and details may be made therein without departing from the scope of the following claims.

## Claims

1. A device configured to transmit first data to an external device and receive second data from the external device, the device comprising:
a voltage mode driver connected to a first node, the voltage mode driver comprising a pull-up resistor circuit and a pull-down resistor circuit, the pull-up resistor circuit comprising a plurality of pull-up resistors, and the pull-down resistor circuit comprising a plurality of pull-down resistors;
a current source circuit connected to a second node and comprising a first current source and a second current source;
a pre-driver configured to control the voltage mode driver and the current source circuit, based on the first data;
a receiver connected to the second node and configured to obtain the second data based on a voltage level of the second node; and
a hybrid resistor connected between the first node and the second node.

2. The device of claim 1, further comprising a calibration circuit,
wherein the calibration circuit comprises:
a first replica current source circuit configured to generate a first calibration current;
a first comparator having a first input terminal and a second input terminal, wherein a first reference voltage is applied to the second input terminal;
a first replica resistor circuit comprising a plurality of first replica resistors;
a first replica hybrid resistor having a first terminal and a second terminal, the first terminal being connected to the first replica resistor circuit and the first input terminal of the first comparator, and the second terminal being connected to an output terminal of the first replica current source circuit;
a second replica current source circuit configured to generate a second calibration current;
a second comparator having a first input terminal and a second input terminal, wherein the first reference voltage is applied to the second input terminal;
a second replica resistor circuit comprising a plurality of second replica resistors; and
a second replica hybrid resistor having a first terminal and a second terminal, the first terminal being connected to the second replica resistor circuit and the first input terminal of the second comparator, and the second terminal being connected to an output terminal of the second replica current source circuit.

3. The device of claim 2, wherein the calibration circuit is configured to:
calibrate the first replica resistor circuit and the second replica resistor circuit, based on a first difference between a voltage of the first input terminal of the first comparator and the first reference voltage;
calibrate the second replica resistor circuit, based on a second difference between a voltage of the first input terminal of the second comparator and the first reference voltage; and
calibrate the voltage mode driver, based on the first difference and the second difference.

4. The device of claim 2 or claim 3, wherein the calibration circuit further comprises a third comparator having a first input terminal and a second input terminal, wherein the first input terminal is connected to the second terminal of the first replica hybrid resistor, and a second reference voltage is applied to the second input terminal, and
wherein the calibration circuit is configured to calibrate the first current source and the second current source, based on a third difference between a voltage of the first input terminal of the third comparator and the second reference voltage.

5. The device of any preceding claim, wherein one end of the first current source is supplied with a power supply voltage, and another end of the first current source is connected to the second node, and
wherein one end of the second current source is connected to the second node, and another end of the second current source is connected to ground.

6. The device of claim 5, wherein the pre-driver is configured, based on the first data having a first value, to disconnect the pull-up resistor circuit from the first node and disconnect the second current source from the second node.

7. The device of claim 5 or claim 6, wherein the pre-driver is configured to, based on the first data having a second value, disconnect all but one of the plurality of pull-up resistors from the first node, disconnect one of the plurality of pull-down resistors from the first node, and disconnect the second current source from the second node, such that a resistance value of the pull-up resistor circuit is greater than than a resistance value of the pull-down resistor circuit.

8. The device of any of claims 5-7, wherein the pre-driver is configured to, based on the first data having a third value:
disconnect one of the plurality of pull-up resistors from the first node;
disconnect all but one of the plurality of pull-down resistors from the first node; and
disconnect the first current source from the second node,
such that a resistance value of the pull-up resistor circuit is less than a resistance value of the pull-down resistor circuit.

9. The device of any of claims 5-8, wherein the pre-driver is configured to, based on the first data having a fourth value, disconnect the pull-down resistor circuit from the first node and disconnect the first current source from the second node.

10. A method of controlling a device for transmitting first data to an external device and receiving second data from the external device, the method comprising:
calibrating a voltage mode driver using a calibration circuit;
calibrating a current source circuit using the calibration circuit;
adjusting a resistance value of a pull-up resistor circuit of the voltage mode driver, based on the first data;
adjusting a resistance value of a pull-down resistor circuit of the voltage mode driver, based on the first data;
adjusting a calibration current of the current source circuit, based on the first data; and
obtaining the second data, based on a voltage level applied to a receiver.

11. The method of claim 10, wherein the device further comprises a hybrid resistor having one end connected to a first node and another end connected to a second node, the second node being connected to an input terminal of the receiver, and
wherein the current source circuit comprises a first current source having one end to which a power supply voltage is applied and another end connected to the second node; and a second current source having one end connected to the second node and another end connected to ground.

12. The method of claim 11, wherein, based on the first data having a first value, the adjusting of the resistance value of the pull-up resistor circuit, the adjusting the resistance value of the pull-down resistor circuit of the voltage mode driver and the adjusting of the current value of the current source circuit comprise disconnecting the first current source from the first node by turning off resistors of the pull-up resistor circuit; and disconnecting the second current source from the second node.

13. The method of claim 11 or claim 12, wherein, based on the first data having a second value, the adjusting of the resistance value of the pull-up resistor circuit, the adjusting the resistance value of the pull-down resistor circuit of the voltage mode driver and the adjusting of the current value of the current source circuit comprise:
disconnecting all but one of a plurality of pull-up resistors included in the pull-up resistor circuit from the first node;
disconnecting one of a plurality of pull-down resistors included in the pull-down resistor circuit from the first node; and
disconnecting the second current source from the second node,
such that a resistance value of the pull-up resistor circuit is greater than a resistance value of the pull-down resistor circuit.

14. The method of any of claims 11-13, wherein, based on the first data having a third value, the adjusting of the resistance value of the pull-up resistor circuit, the adjusting of the resistance value of the pull-down resistor circuit of the voltage mode driver and the adjusting of the current value of the current source circuit comprise:
disconnecting one of a plurality of pull-up resistors included in the pull-up resistor circuit from the first node;
disconnecting all but one of a plurality of pull-down resistors included in the pull-down resistor circuit from the first node; and
disconnecting the first current source from the second node,
such that a resistance value of the pull-up resistor circuit is less than a resistance value of the pull-down resistor circuit.

15. The method of any of claims 11-14, wherein, based on the first data having a fourth value, the adjusting of the resistance value of the pull-up resistor circuit, the adjusting of the resistance value of the pull-down resistor circuit of the voltage mode driver and the adjusting of the current value of the current source circuit comprise:
disconnecting the pull-down resistor circuit from the first node; and
disconnecting the first current source from the second node.
